# EUROPEAN PATENT APPLICATION

(11) **EP 4 753 405 A1**
(43) Date of publication of application: **03.06.2026**
(21) Application number: 25853521.0
(22) Date of filing: 15.05.2025
(51) Int. Cl.: H10F 19/90

(54) **BACK CONTACT CELL ASSEMBLY AND PHOTOVOLTAIC SYSTEM**

(30) Priority: 12.08.2024 CN 202411104383; 29.08.2024 CN 202411205553
(71) Applicant: Zhuhai Fushan Aiko Solar Technology Co., Ltd., Zhuhai, Guangdong 519000 (CN); Tianjin Aiko Solar Energy Technology Co., Ltd., Tianjin 300400 (CN); Guangdong Aiko Solar Energy Technology Co., Ltd., Foshan, Guangdong 528000 (CN); Zhejiang Aiko Solar Energy Technology Co., Ltd., Yiwu, Jinhua Zhejiang 322000 (CN); Shandong Aiko Solar Technology Co., Ltd, Jinan, Shandong 250000 (CN); Chuzhou Aiko Solar Technology Co., Ltd., Chuzhou, Anhui 239514 (CN); Shenzhen Aiko Digital Energy Engineering Co., Ltd, Shenzhen, Guangdong 518000 (CN)
(72) Inventor: XU, Zhigang, Jinhua, Zhejiang 322000 (CN); XU, Yang, Jinhua, Zhejiang 322000 (CN); CHEN, Gang, Jinhua, Zhejiang 322000 (CN)
(74) Representative: Cohausz & Florack
(86) International application number: PCT/CN2025/095221
(87) International publication number: WO 2026/036819

(57) **Abstract**

The present disclosure is applicable to the technical field of solar cells, and provides a back-contact cell module and a photovoltaic system. The back-contact cell module includes a cell string, a solder strip, a conductive connection structure and an insulation structure. A first cell piece and a second cell piece are arranged in a first direction. The first cell piece and the second cell piece are at least partially stacked together. A first grid line and a second grid line extend in a second direction and are alternately arranged in the first direction. The solder strip is disposed on a back surface of the first cell piece and extends in the first direction. An accommodation space is formed between one side of the first cell piece close to the second cell piece and the solder strip. The conductive connection structure is at least partially laid within the accommodation space and configured to connect the first grid line within the accommodation space and the solder strip. As such, the solder strip can be connected to the first grid line within the accommodation space by means of the conductive connection structure, such that an electric current within the accommodation space can be collected, and further the power generation efficiency of the back-contact cell module is improved.

## Description

### Cross Reference to Related Applications

The present disclosure claims the priority of Chinese patent application entitled "Back-Contact Cell Module and Photovoltaic System" filed to the China National Intellectual Property Administration on August 12, 2024, with the application number of 202411104383.7 and the priority of Chinese patent application entitled "Back-Contact Cell Module and Photovoltaic System" filed to the China National Intellectual Property Administration on August 29, 2024, with the application number of 202411205553.0, the entire contents of which are incorporated herein by reference.

### Technical Field

The present disclosure belongs to the technical field of solar cells, and particularly relates to a back-contact cell module and a photovoltaic system.

### Background

Currently, a back-contact cell refers to a solar cell in which a light receiving surface of a cell piece has no electrodes, with both an anode and a cathode disposed on a backlight surface of the cell piece, thereby reducing shielding of the cell piece by the electrodes, increasing a short-circuit current of the cell piece, and improving the energy conversion efficiency of the cell piece. In the related art, edges of a plurality of the back-contact cells are stacked together, which can increase a light receiving area of the cell. However, when the back-contact cells are stacked together, an electric current at the edge of one of the back-contact cells cannot be collected, resulting in the decrease in the power generation efficiency of the cell.

### Summary

Embodiments of the present disclosure provide a back-contact cell module and a photovoltaic system, aiming to solve the problem that an electric current at an edge cannot be collected when a stacked structure is used in a photovoltaic cell.

Embodiments of the present disclosure provide a back-contact cell module, including a cell string, a solder strip, a conductive connection structure and an insulation structure. The cell string includes a first cell piece and a second cell piece adjacent to the first cell piece. The first cell piece and the second cell piece are arranged in a first direction. The first cell piece and the second cell piece are at least partially stacked together. A first grid line and a second grid line are formed on back surfaces of the first cell piece and the second cell piece. The first grid line and the second grid line extend in a second direction and are alternately arranged in the first direction. The first grid line has a polarity opposite to a polarity of the second grid line. The solder strip is disposed on the back surface of the first cell piece and extends in the first direction. An accommodation space is formed between one side of the first cell piece close to the second cell piece and the solder strip. The conductive connection structure is at least partially laid within the accommodation space, and configured to connect the first grid line within the accommodation space and the solder strip. The insulation structure covers the second grid line. The insulation structure is disposed within the accommodation space and positioned between the second grid line and the solder strip.

In some embodiments, a length L of the conductive connection structure in the first direction meets the following relationship: 0 < L≤D/tanα, wherein α is an included angle between a direction in which the solder strip is lifted and the first direction, D is a thickness of the second cell piece in a third direction, and the third direction is perpendicular to the second direction and the first direction.

In some embodiments, the solder strip includes a first solder strip, wherein the first solder strip extends in the first direction and connects the back surface of the first cell piece and the back surface of the second cell piece, and the accommodation space is formed between one side of the first cell piece close to the second cell piece and the solder strip.

In some embodiments, when the back surface of the first cell piece and a front surface of the second cell piece are at least partially stacked together, the accommodation space is formed at one side of the back surface of the first cell piece close to the second cell piece. The solder strip further includes a second solder strip and a third solder strip, wherein the second solder strip is disposed on the back surface of the first cell piece and at least partially extends into the back surface of the second cell piece, and the third solder strip is positioned on the back surface of the second cell piece.

In some embodiments, the back-contact cell module further includes a busbar disposed on the back surface of the second cell piece;
the busbar is connected to the second solder strip and positioned at one side of the second solder strip facing away from the second cell piece; or
the busbar is connected to the second solder strip and positioned at one side of the second solder strip facing away from the second cell piece.

In some embodiments, when the front surface of the first cell piece and the back surface of the second cell piece are at least partially stacked together, the accommodation space is formed at one side of the back surface of the first cell piece close to the second cell piece. The solder strip further includes a second solder strip and a third solder strip, wherein the second solder strip is disposed on the back surface of the first cell piece and at least partially extends into the back surface of the second cell piece, and the third solder strip is positioned on the back surface of the second cell piece.

In some embodiments, the back-contact cell module further includes a busbar disposed on the back surface of the first cell piece;
the busbar is connected to the second solder strip and positioned at one side of the second solder strip facing away from the first cell piece; or
the busbar is connected to the second solder strip and positioned at one side of the second solder strip close to the first cell piece.

In some embodiments, the insulation structure is fabricated in a laying or coating manner.

In some embodiments, the conductive connection structure is a solder paste, a conductive adhesive or a further metal conductive material.

In some embodiments, a length of the conductive connection structure in the first direction is greater than 6mm.

In some embodiments, a thickness of the conductive connection structure in a third direction ranges from 30µm to 300µm, wherein the third direction is perpendicular to the first direction and the second direction.

In some embodiments, in the second direction, a width of the solder strip is greater than a width of the conductive connection structure.

In some embodiments, in the second direction, a width of the insulation structure is greater than a width of the conductive connection structure.

In some embodiments, a thickness of the insulation structure ranges from 25µm to 40µm.

In some embodiments, an inclined surface is formed on one side of the conductive connection structure away from the first cell piece, and the inclined surface is connected to the solder strip.

In some embodiments, the back-contact cell module further includes an insulation layer disposed between the busbar and the third solder strip.

In some embodiments, an included angle α between a direction in which the solder strip is lifted and the first direction is adjusted according to a yield strength of the solder strip.

In some embodiments, the yield strength of the solder strip is adjusted to be less than or equal to 75MPa.

In some embodiments, a thickness D of the second cell piece in the third direction ranges from 90µm to 200µm.

The photovoltaic system provided in embodiments of the present disclosure includes the cell module as described in any one of the above embodiments.

In the back-contact cell module and the photovoltaic system of embodiments of the present disclosure, the back-contact cell module includes the cell string, the solder strip, the conductive connection structure and the insulation structure. The cell string includes the first cell piece and the second cell piece adjacent to the first cell piece. The first cell piece and the second cell piece are arranged in the first direction. The first cell piece and the second cell piece are at least partially stacked together. The first grid line and the second grid line are formed on the back surfaces of the first cell piece and the second cell piece. The first grid line and the second grid line extend in the second direction and are alternately arranged in the first direction. The first grid line has the polarity opposite to the polarity of the second grid line. The solder strip is disposed on the back surface of the first cell piece and extends in the first direction. The accommodation space is formed between one side of the first cell piece close to the second cell piece and the solder strip. The conductive connection structure is at least partially laid within the accommodation space and configured to connect the first grid line within the accommodation space and the solder strip. The insulation structure is disposed within the accommodation space and positioned between the second grid line and the solder strip. As such, the solder strip can be connected to the first grid line within the accommodation space by means of the conductive connection structure, such that the electric current within the accommodation space can be collected, and further the power generation efficiency of the back-contact cell module is improved. Meanwhile, the insulation structure can be disposed between the second grid line and the conductive connection structure to avoid the problem of short circuits.

### Brief Description of Drawings

Fig. 1 is a schematic diagram showing a partial planar structure of a back-contact cell according to an embodiment of the present disclosure;
Fig. 2 is a schematic diagram showing a partial cross-sectional structure of a back-contact cell according to an embodiment of the present disclosure;
Fig. 3 is another schematic diagram showing a partial cross-sectional structure of a back-contact cell according to an embodiment of the present disclosure;
Fig. 4 is a schematic enlarged view of A in Fig. 3 according to an embodiment of the present disclosure;
Fig. 5 is further schematic diagram showing a partial cross-sectional structure of a back-contact cell according to an embodiment of the present disclosure;
Fig. 6 is yet another schematic diagram showing a partial cross-sectional structure of a back-contact cell according to an embodiment of the present disclosure;
Fig. 7 is yet further schematic diagram showing a partial cross-sectional structure of a back-contact cell according to an embodiment of the present disclosure;
Fig. 8 is yet further schematic diagram showing a partial cross-sectional structure of a back-contact cell according to an embodiment of the present disclosure;
Fig. 9 is a schematic diagram showing a modular structure of a back-contact cell according to an embodiment of the present disclosure; and
Fig. 10 is a schematic diagram showing a modular structure of a photovoltaic system according to an embodiment of the present disclosure.

Description of reference symbols of main components:
100: back-contact cell module; 10: first cell piece; 11: front surface; 12: back surface; 121: first grid line; 122: second grid line; 20: second cell piece; 30: solder strip; 31: accommodation space; 32: first solder strip; 33: second solder strip; 34: third solder strip; 40: conductive connection structure; 41: inclined surface; 50: insulation structure; 60: busbar; 70: insulation layer; 200: cell string; and 300: photovoltaic system.

### Detailed Description of Embodiments

In order to make the objectives, technical solutions and advantages of the present disclosure clearer, the present disclosure will be further described in detail below with reference to accompanying drawings and embodiments. Examples of embodiments described herein are shown in the accompanying drawings, in which the same or similar reference symbols denote the same or similar elements or elements having the same or similar functions throughout. Embodiments described below with reference to the accompanying drawings are exemplary, are provided merely for the purpose of illustrating the present disclosure, and should not be construed as a limitation to the present disclosure. Further, it should be understood that specific embodiments described herein are merely used for describing the present disclosure rather than limiting the present disclosure.

In the description of the present disclosure, it should be understood that orientational or positional relationships indicated by terms such as "length", "width", "upper", "lower", "left", "right", "horizontal", "top" and "bottom" are based on orientational or positional relationships shown in the accompanying drawings, are only for the purpose of facilitating the description of the present disclosure and simplifying the description, but are not intended to indicate or imply that the apparatus or component referred to must have a particular orientation or be constructed and operated in a particular orientation. Therefore, such terms should not be construed as a limitation to the present disclosure.

In addition, terms "first" and "second" are used for a descriptive purpose only and should not be construed as indicating or implying relative importance or implying a quantity of technical features indicated. Thereby, a feature defined by "first" or "second" may explicitly or implicitly include one or more of such features. In the description of the present disclosure, "a plurality of" means two or more, unless otherwise explicitly and particularly defined.

In the description of the present disclosure, it should be noted that, unless otherwise explicitly specified or defined, terms such as "install", "connect" and "connection" shall be construed broadly. For example, they may be a fixed connection, a detachable connection, or an integral connection; they may be a mechanical connection, an electrical connection or a mutual communication; and they can be a direct connection or an indirect connection via an intermediate medium, and they can be an internal communication between two components or an interaction relationship between the two components. Specific meanings of the above terms in the present disclosure may be understood depending on specific circumstances for those ordinarily skilled in the art.

In the present disclosure, unless otherwise expressly specified or defined, a first feature being "on" or "under" a second feature may involve the first feature being in contact with the second feature, or the first feature is not in direct contact with the second feature but rather is in contact with the second feature through a further feature therebetween. Moreover, the first feature being "on", "above", and "over" the second feature involves the first feature being directly above and obliquely above the second feature, or simply indicates that the first feature is horizontally higher than the second feature. The first feature being "under", "below" and "underneath" the second feature involves the first feature being directly below and obliquely below the second feature, or simply indicates that the first feature is horizontally lower than the second feature.

The description below provides a number of different embodiments or examples to implement different structures of the present disclosure. In order to simplify the description of the present disclosure, parts and settings of specific examples will be described below. Certainly, they are only examples and are not intended to limit the present disclosure. In addition, reference numbers and/or reference letters may be repeated in different examples of the present disclosure, and such a repetition is for the purposes of simplification and clarity and does not in itself indicate the relationship between various embodiments and/or settings in question. Further, although the present disclosure provides examples of various specific processes and materials, applications of further processes and/or use scenarios of further materials can occur in those ordinarily skilled in the art.

In the related art, a solar cell is a semiconductor device directly converting energy of sunlight into electric energy. The solar cell uses the photovoltaic effect to excite electrons by absorbing photons and export the electrons to generate electric currents through a built-in electric field. A back-contact cell refers to a solar cell in which a light receiving surface of a cell piece has no electrodes, with both an anode and a cathode disposed on a backlight surface of the cell piece, thereby reducing shielding of the cell piece by the electrodes, increasing a short-circuit current of the cell piece, and improving the energy conversion efficiency of the cell piece. In the prior art, in order to achieve a large light receiving area of the back-contact cell and eliminate gaps between different cell pieces, edge portions of two adjacent cell pieces are stacked together in the back-contact cell. However, this leads to outcomes that fine grids at the edge portions cannot be connected by the solder strip and further the electric currents at the edge portions cannot be collected, and further results in the decrease of the power generation efficiency of the cell. In embodiments of the present disclosure, a conductive connection structure is disposed at the edge portions to connect the solder strip and the corresponding fine grid, which in turn collects all the electric currents of the cell pieces, such that the power generation efficiency is improved.

### Embodiment 1

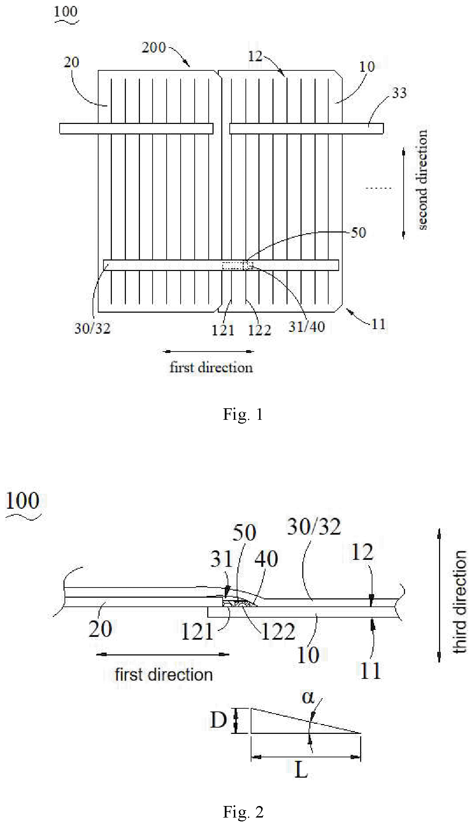

Referring to Fig. 1 to Fig. 4, embodiments of the present disclosure provide a back-contact cell module 100, including a cell string 200, a solder strip 30, a conductive connection structure 40 and an insulation structure 50. The cell string 200 includes a first cell piece 10 and a second cell piece 11 adjacent to the first cell piece 10. The first cell piece 10 and the second cell piece 11 are arranged in a first direction. The first cell piece 10 and the second cell piece 11 are at least partially stacked together. A first grid line 121 and a second grid line 122 are formed on back surfaces 12 of the first cell piece 10 and the second cell piece 20. The first grid line 121 and the second grid line 122 extend in a second direction and are alternately arranged in the first direction. The first grid line 121 has a polarity opposite to that of the second grid line 122. The solder strip 30 is disposed on the back surface 12 of the first cell piece 10 and extends in the first direction. An accommodation space 31 is formed between one side of the first cell piece 10 close to the second cell piece 20 and the solder strip 30. The conductive connection structure 40 is at least partially laid within the accommodation space 31 and configured to connect the first grid line 121 within the accommodation space 31 and the solder strip 30. The insulation structure 50 covers the second grid lines 122. The insulation structure 50 is disposed within the accommodation space 31 and positioned between the second grid line 122 and the solder strip 30.

In some embodiments, a length L of the conductive connection structure 40 in the first direction meets the following relationship: 0 < L≤D/tanα, wherein α is an included angle between a direction in which the solder strip 30 is lifted and the first direction, D is a thickness of the second cell piece 20 in a third direction, and the third direction is perpendicular to the second direction and the first direction.

In some embodiments, the solder strip 30 includes a first solder strip 32, wherein the first solder strip 32 extends in the first direction and connects the back surface 12 of the first cell piece 10 and the back surface 12 of the second cell piece 20, and the accommodation space 31 is formed between one side of the first cell piece 10 close to the second cell piece 20 and the solder strip 32.

In the back-contact cell module 100 of embodiments of the present disclosure, the back-contact cell module 100 includes the cell string 200, the solder strip 30, the conductive connection structure 40 and the insulation structure 50. The cell string 200 includes the first cell piece 10 and the second cell piece 11 adjacent to the first cell piece 10. The first cell piece 10 and the second cell piece 11 are arranged in the first direction. The first cell piece 10 and the second cell piece 11 are at least partially stacked together. The first grid line 121 and the second grid line 122 are formed on the back surfaces 12 of the first cell piece 10 and the second cell piece 20. The first grid line 121 and the second grid line 122 extend in the second direction and are alternately arranged in the first direction. The first grid line 121 has the polarity opposite to that of the second grid line 122. The solder strip 30 is disposed on the back surface 12 of the first cell piece 10 and extends in the first direction. The accommodation space 31 is formed between one side of the first cell piece 10 close to the second cell piece 20 and the solder strip 30. The conductive connection structure 40 is at least partially laid within the accommodation space 31, and configured to connect the first grid line 121 within the accommodation space 31 and the solder strip 30. The insulation structure 50 covers the second grid line 122. The insulation structure 50 is disposed within the accommodation space 31 and positioned between the second grid line 122 and the solder strip 30. As such, the solder strip 30 can be connected to the first grid line 121 within the accommodation space 31 by means of the conductive connection structure 40, such that an electric current within the accommodation space 31 can be collected, and further the power generation efficiency of the back-contact cell module 100 is improved. Meanwhile, the insulation structure 50 can be disposed between the second grid line 122 and the conductive connection structure 40 to avoid the problem of short circuits.

In such an embodiment, a front surface 11 of a cell piece is configured to receive light while a back surface 12 of the cell piece includes a plurality of first doped layers and second doped layers (not shown in the figures) which are alternately arranged. The first grid line 121 is disposed on the first doped layers, and the second grid line 122 is disposed on the second doped layers. The first grid line 121 and the second grid line 122 extend in the second direction and are alternately disposed in the first direction. Moreover, the first doped layers and the second doped layers extend in the second direction and are alternately arranged in the first direction so as to form a photocurrent.

In embodiments of the present disclosure, the back surface 12 of the cell piece has no busbar, and the first grid line 121 and the second grid line 122 can achieve current collection directly by means of the solder strip 30. The solder strip 30 includes a first solder strip 32 and a second solder strip 33. The first solder strip 32 and the second solder strip 33 extend in the first direction and are alternately arranged in the second direction. Moreover, the first grid line 121 has the polarity opposite to that of the second grid line 122. The first solder strip 32 can connect the first grid line 121 of the first cell piece 10 and the second grid line 122 of the second cell piece 20, so as to connect the first cell piece 10 and the second cell piece 20 in series. Furthermore, there is another second solder strip 33 for connecting the first grid line 121 of the second capacitor 20 and the busbar 60. In embodiments of the present disclosure, no restrictions are made to relative positions between the busbar 60 and the second solder strip 33, so as to meet various requirements. In this case, the insulation structure 50 is disposed between the first solder strip 32 and the second grid line 122 of the first cell piece 10 to achieve insulation. The insulation structure 50 is disposed between the first solder strip 32 and the first grid line 121 of the second cell piece 20 to achieve insulation.

In embodiments of the present disclosure, the first cell piece 10 and the second cell piece 20 are at least partially stacked together, which avoids wasting the space of the module due to an excessive spacing and increasing the cost. The accommodation space 31 is formed between one side of the first cell piece 10 close to the second cell piece 20 and the solder strip 30. The conductive connection structure 40 is at least partially laid within the accommodation space 31 and configured to connect the first grid line 121 within the accommodation space 31 and the solder strip 30. The insulation structure 50 covers the second grid lines 122. The insulation structure 50 is disposed within the accommodation space 31 and positioned between the second grid line 122 and the solder strip 30. In this way, the electric currents generated by the first doped layers corresponding to the first grid line 121 inside the accommodation space 31 can be derived by means of the solder strip 30, such that all the doped layers of the cell piece generate electric energy, and further the power generation efficiency of the back-contact cell module 100 is improved. Certainly, in some embodiments, the conductive connection structure 40 is filled within the entire accommodation space 31, such that all the first grid lines 121 inside the accommodation space 31 can be connected and led out by means of the solder strip 30.

Particularly, when the first grid line 121 is an anode grid line and the second grid line 122 is a cathode grid line, the first solder strip 32 can span across the first cell piece 10 and the second cell piece 20, and connect the first grid line 121 of the first cell piece 10 and the second grid line 122 of the second cell piece 20. That is to say, the first solder strip 32 can connect the anode grid line of the first cell piece 10 and the cathode grid line of the second cell piece 20. In this case, the insulation structure 50 can be disposed on the second grid line 122 of the first cell piece 10 and on the first grid line 121 of the second cell piece 20, so as to connect the first cell piece 10 and the second cell piece 20 in series.

In some embodiments, the cell string 200 can further include a current collection structure to collect electric currents of a plurality of cell pieces. The current collection structure can be connected to the solder strip 30 of the same polarity so as to form a loop with the cell string 200 to export energy of the electric currents. The plurality of cell pieces can be connected in series by means of the solder strip 30 so as to form the cell string 200 arranged in the first direction. Certainly, in some embodiments, the solder strip 30 positioned at an end portion of the cell string 200 can only connect the grid line on one cell piece, and extend relative to the cell piece so as to connect structures such as the busbar 60. In addition, in embodiments of the present disclosure, no restrictions are made to a form of the current collection structure so as to meet different requirements. For example, the current collection structure can be a conductive material such as a wire, the busbar 60 and a conductive adhesive tape.

In some embodiments, an included angle α between a direction in which the solder strip 30 is lifted and the first direction is adjusted according to a yield strength of the solder strip 30. As such, the solder strips 30 with different yield strengths can be selected to adjust the included angle α, and then a specific size of the length L of the conductive connection structure 40 in the first direction is calculated according to a thickness of the cell piece. In this way, the length of the conductive connection structure 40 in the accommodation space 31 in the first direction can be adjusted, and further the usage amount of the conductive connection structure 40 can be adjusted, which not only ensures that the conductive connection structure 40 can connect the solder strip 30 and the first grid line 121within the accommodation space 31, but also avoids wasting a material forming the conductive connection structure 40.

In some embodiments, the yield strength of the solder strip 30 is adjusted to be less than or equal to 75MPa. As such, the yield strength of the solder strip 30 is less than or equal to 75Mpa, which ensures that the solder strip 30 can be bent and formed at a pressure of 75Mpa and avoids affecting further components.

In some embodiments, a thickness D of the second cell piece 20 in the third direction ranges from 90µm to 200µm.For example, the thickness D of the second cell piece 20 in the third direction can be 90µm, 100µm, 110µm, 120µm, 130µm, 140µm, 150µm, 160µm, 170µm, 180µm, 190µm or 200µm.

As such, the thickness D of the second cell piece 20 in the third direction is set within this range, which can ensure that cell pieces with various specifications are encompassed and different requirements are further met.

Particularly, the thickness D of the second cell piece 20 in the third direction preferably ranges from 90µm to 150µm. In this way, the structure stability and the operation stability of the cell piece are ensured without increasing the thickness of the back-contact cell module 100.

Exemplarily, the thickness D of the second cell piece 20 in the third direction can be 120µm, and the yield strength of the solder strip 30 can be 70Mpa, which ensures the fabricating stability in a process without affecting further components, while reducing a size of the accommodation space 31, optimizes the usage amount of the material forming the conductive connection structure 40, and enables the conductive connection structure 40 to stably connect the solder strip 30 and the first grid line 121 within the accommodation space 31.

It should be noted that the yield strength of the solder strip 30 refers to a pressure required for bending the solder strip 30 to a desired shape.

It should be understood that "first" and "second" in the first cell piece 10 and the second cell piece 20 refer to relative concepts, indicating that two back-contact cells are different. For example, in an example of Fig. 1, the cell piece on the left is labelled as the second cell piece 20, and the cell piece on the right is labelled as the first cell piece 10.

It should be understood that in the cell string 200, the cell string 200 may include two cell pieces connected in series, three cell pieces connected in series or further more cell pieces. Particularly, the number of the cell pieces required to be connected in series can be determined according to the actual usage. In addition, in embodiments of the present disclosure, no restrictions are made to sizes and types of the cell pieces. Specifications and sizes of adjacent cell pieces may be the same or different so as to meet different requirements.

In embodiments of the present disclosure, no restrictions are made to doping types of the first doped layers and the second doped layers. For example, the first doped layers and the second doped layers can be P-type doped layers and N-type doped layers, respectively, or the first doped layers can be N-type doped layers and the second doped layers can be P-type doped layers, provided that the first doped layers have a polarity opposite to that of the second doped layers so as to meet different requirements. In some embodiments, the first doped layers can be P-type polycrystalline silicon layers, P-type amorphous silicon layers or P-type microcrystalline silicon layers, which is not particularly limited here. Similarly, the second doped layers can be N-type polycrystalline silicon layers, N-type amorphous silicon layers or N-type microcrystalline silicon layers, which is not particularly limited here. When the first doped layers are the P-type doped layers and the second doped layers are the N-type doped layers, a P-type grid line can be disposed on the first doped layers, and an N-type grid line can be disposed on the second doped layers, which is not particularly limited here.

In some embodiments, p-type doping refers to doping of group-III elements including elements such as boron, aluminum, gallium, indium and thallium, and. N-type doping refers to doping of Group-V elements including elements such as nitrogen, phosphorus, arsenic, antimony and bismuth, which is not particularly limited here.

In addition, in some embodiments, the first doped layers and the second doped layers can be co-doped, for example, the N-type doping may further include a small amount of P-type doping elements, wherein the content of the N-type doping elements is higher than 20% of the content of the P-type doping elements in the second doped layers so as to ensure that the second doped layers have the polarity opposite to that of the first doped layers.

It should be understood that in such embodiments, the back-contact cell module 100 may further include a frame, a backboard, photovoltaic glass and an adhesive film. The adhesive film can be filled among the front surface 11 and the back surface 12 of the cell piece and the photovoltaic glass, adjacent cell pieces and the like as a filler, and can be a transparent adhesive with good light transmittance and aging resistance. For example, the adhesive film can be either an EVA adhesive film or a POE adhesive film, and can be selected according to an actual situation, which will not be limited here.

The photovoltaic glass can cover the adhesive film on the front surface 11 of the cell piece. The photovoltaic glass can be ultra-clear glass with high light transmittance, high transparency, and excellent physical, mechanical and optical properties. For example, the light transmittance of the ultra-clear glass can reach more than 92%, such that the ultra-clear glass can protect the cell piece without affecting the efficiency of the cell piece as much as possible. Moreover, the adhesive film can adhere the photovoltaic glass and the cell piece together. The adhesive film can be used to seal, insulate and protect the cell piece from being influenced by water or moisture.

The backboard can be attached to the adhesive film on the back surface 12 of the cell piece. The backboard can protect and support the cell piece, and has reliable insulation, water resistance and aging resistance. In general, the backboard can have multiple forms, such as tempered glass, organic glass and an aluminum alloy TPT composite adhesive film, and can be particularly set according to a specific situation, which will not be limited here. An assembly composed of the backboard, the cell piece, the adhesive film and the photovoltaic glass can be arranged on the frame. The frame, as a main external supporting structure of the entire back-contact cell module 100, can allow the back-contact cell module 100 to be stably supported and installed. For example, the back-contact cell module 100 can be installed at a required position by means of the frame.

### Embodiment 2

Referring to Fig. 1 and Fig. 2, in some alternate embodiments, at least some first grid lines 121 and second grid lines 122 are disposed within the accommodation space 31. All the first grid lines 121 disposed within the accommodation space 31 are connected to the solder strip 30 by means of the conductive connection structure 40.

As such, the first grid lines 121 and the second grid lines 122 are alternately disposed within the accommodation space 31 in the first direction. In this way, electric currents of the first doped layers and the second doped layers within the accommodation space 31 can be derived, and further the power generation efficiency of the cell piece is improved.

Particularly, some first grid lines 121 and some second grid lines 122 are disposed within the accommodation space 31, and connected to the solder strip 30 by means of the conductive connection structure 40. The first grid lines 121 and the second grid lines 122 are alternately disposed within the accommodation space 31 in the first direction. All the first grid lines 121 disposed within the accommodation space 31 are connected to the solder strip 30 by means of the conductive connection structure 40. In this way, the electric currents of the first doped layers and the second doped layers within the accommodation space 31 can be effectively derived, and further the power generation efficiency of the cell piece is improved. Accordingly, the electric currents of the doped layers can be collected and conducted fully by optimizing a design connecting the grid lines and the solder strip 30, and further the power generation efficiency of the cell piece is improved. The conductive connection structure 40 within the accommodation space 31 reduces the impedance in a current conduction path, reduces the loss of the electric energy, and improves the overall power generation performance. Due to the conductive connection structure 40, efficient conduction of the electric currents is ensured while the stability of connecting the cell piece and the solder strip 30 is improved. As a result, poor contact caused by mechanical stress or environmental changes is eliminated.

### Embodiment 3

Referring to Fig. 1 and Fig. 2, in some alternate embodiments, the insulation structure 50 is fabricated in a laying or coating manner.

As such, the insulation structure 50 can be fabricated in a laying or coating manner, such that the insulation structure 50 can be accurately disposed on the corresponding grid lines. In addition, the insulation structure 50 can be fabricated on the cell piece in various fabrication approaches so as to meet various scenario requirements.

It should be understood that the first grid lines 121 and the second grid lines 122 extend in the second direction and are alternately laid on the cell piece in the first direction. In the second direction, two end portions of each of the first grid lines 121 and the second grid lines 122 can extend into positions close to the edge of the cell piece. In this case, a plurality of solder strips 30 can be disposed on the cell piece to connect the grid lines having the same polarity on the cell. The solder strips 30 can continuously pass through the plurality of first grid lines 121 and second grid lines 122 because of extending in the first direction. In this case, the insulation structure 50 is disposed on a position of the second grid line 122 covered by the solder strip 30, so as to avoid being connected to the second grid line 122. The insulation structure 50 is disposed between the second grid line 122 and the solder strip 30, so as to prevent the solder strip 30 from being connected to the second grid line 122, thereby eliminating the problem of short circuits.

In embodiments of the present disclosure, no restrictions are made to a form of the insulation structure and the fabrication approach so as to meet different requirements. In one embodiment, the insulation structure 50 is an insulation adhesive layer applied to the corresponding grid line by means of a spraying process. As such, a position where the insulation structure 50 is disposed is accurate, and the speed of disposing the insulation structure 50 is high. Further, a spraying device is not in direct contact with the cell piece, which reduces the contamination and damage to the cell piece. Further, the insulation adhesive layer can be subjected to at least one of photocuring and thermal curing, wherein the duration of the photocuring is less than or equal to 2s.

### Embodiment 4

Referring to Fig. 1 and Fig. 2, in some alternate embodiments, the conductive connection structure 40 is a solder paste, a conductive adhesive or a further metal conductive material.

As such, the conductive connection structure 40 is a material easy to deform, such as the solder paste or the conductive adhesive, and can adapt to the irregular accommodation space 31 occurring in a fabrication process. As a result, the conductive connection structure 40 can connect the first grid line 121 and the solder strip 30.

In embodiments of the present disclosure, no restrictions are made to a type of the conductive connection structure 40 so as to meet different requirements. In an example, when the conductive connection structure 40 is the solder paste, the solder paste is suitable for filling an irregular space due to good wettability and flowability, and ensures the electrical connection stability. In another example, when the conductive connection structure 40 is the conductive adhesive, the conductive adhesive can be closely adhered between the grid line and the solder strip 30 due to flexibility and good adhesiveness, and adapt to the accommodation spaces 31 with different shapes and sizes. In further example, when the conductive connection structure 40 is made of the further metal conductive material, the metal conductive material can ensure the efficient conduction of the electric currents due to excellent electrical conductivity. Smooth conduction of the electric currents can be ensured because of the flexibility and conductivity of these materials, and further the power generation efficiency of the back-contact cell module 100 can be improved.

Further, the irregular accommodation space 31 is prone to occur in the fabrication process since the solder strip 30 is disposed on the first cell piece 10 and the second cell piece 20 in a stretching manner. When the conductive connection structure 40 is the solder paste, the conductive adhesive or the further metal conductive material, the flexibility of the fabrication process can be improved. The solder paste and the conductive adhesive can be applied by using a simple coating or dispensing process during the use, with easy operation and low cost. In addition, the conductive connection structure 40 can adapt to the irregular accommodation space 31 occurring in the fabrication process due to inherent fluidity and plasticity of the material. As a result, the integrity and reliability of the conductive connection structure 40 are ensured.

### Embodiment 5

Referring to Fig. 1 and Fig. 2, in some alternate embodiments, the length of the conductive connection structure 40 in the first direction is greater than 6mm. For example, the length of the conductive connection structure 40 in the first direction may be 6.1mm, 6.2mm, 6.3mm, 6.4mm, 6.5mm, 6.6mm, 6.7mm, 6.8mm, 6.9mm, 7mm, 7.5mm or 8mm.

As such, in the fabrication process, the solder strip 30 can be connected to the first cell piece 10 and the second cell piece 20, and the accommodation spaces 31 generally have different sizes. Therefore, the conductive connection structure 40 is set to have a length greater than 6mm in the first direction, such that the conductive connection structure 40 can connect all the first grid lines 121 within the accommodation structure under different process errors.

Particularly, in embodiments of the present disclosure, no restrictions are made to a type of the solder strip 30 so as to meet different requirements. For example, the solder strip 30 can be a round solder strip 30 or a flat wide solder strip 30. It should be noted that when the solder strip 30 is disposed on the first cell piece 10 and the second cell piece 20, the length of the accommodation space 31 in the first direction is non-uniform due to process errors. The length of the accommodation space 31 in the first direction ranges from 0.5mm to 6mm. As a result, it is necessary for enabling the length of the conductive connection structure 40 in the first direction to be greater than 6mm. Exemplarily, the length of the conductive connection structure 40 in the first direction is 7mm, which can effectively connect the first grid line 121 within the accommodation space 31 and the solder strip 30, thereby ensuring the connection stability.

### Embodiment 6

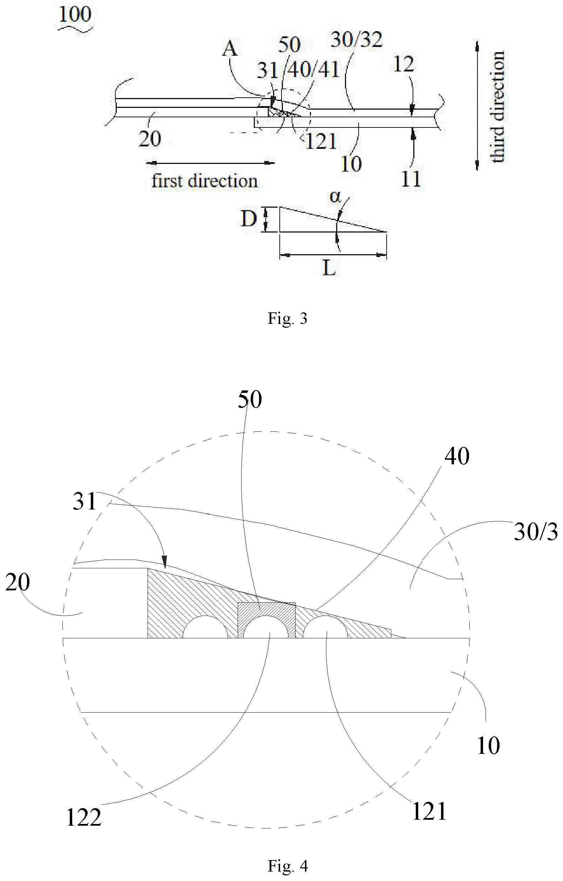

Referring to Fig. 2 and Fig. 3, in some alternate embodiments, a thickness of the conductive connection structure 40 in the third direction ranges from 30µm to 300µm, wherein the third direction is perpendicular to the first direction and the second direction. For example, the thickness of the conductive connection structure 40 in the third direction can be 30µm, 40µm, 50µm, 60µm, 70µm, 80µm, 90µm, 100µm, 120µm, 140µm, 160µm, 180µm, 200µm, 220µm, 240µm, 260µm, 280µm or 300µm.

As such, the thickness of the conductive connection structure 40 is set within this range, such that it is possible to avoid the problem of insufficient or missed soldering due to excessively small thickness of the conductive connection structure 40, and to prevent the overall thickness of the back-contact cell module 100 from being affected due to excessively large thickness of the conductive connection structure 40.

### Embodiment 7

Referring to Fig. 1 and Fig. 2, in some alternate embodiments, in the second direction, a width of the solder strip 30 is greater than that of the conductive connection structure 40.

As such, the solder strip 30 can shield the conductive connection structure 40 to prevent the conductive connection structure 40 from being exposed and to further avoid any interference with the normal operation of the back-contact cell module 100. The exposed conductive connection structure 40 is prone to be in contact with further conductive components or lines, resulting in short circuits. Furthermore, since the material used in the conductive connection structure 40 has a certain flexibility and elasticity, shielding the conductive connection structure 40 with the solder strip 30 prevents the conductive connection structure 40 from being extruded and further exposed when the solder strip 30 is pressed against the conductive connection structure 40. In this way, the durability and reliability of the components are improved, the problems such as mechanical damage or oxidization of the conductive connection structure 40 can be avoided, and further the service life and performance stability of the back-contact cell module 100 are increased.

### Embodiment 8

Referring to Fig. 1 and Fig. 2, in some alternate embodiments, in the second direction, a width of the insulation structure 50 is greater than that of the conductive connection structure 40.

As such, in the second direction, the width of the insulation structure 50 is greater than that of the conductive connection structure 40, so as to prevent the conductive connection structure 40 from being in short circuit with the second grid line 122.

Particularly, the widened insulation structure 50 provides an increased physical isolation region, which enhances the electrical insulation effect, and avoids possible electrical interference and electric current leakage. In an actual production process, the process errors may result in minor deviations in the position of the conductive connection structure 40. The widened insulation structure 50 can compensate for these deviations and ensure that the insulation effect is not affected. In addition, the widened insulation structure 50 can eliminate insulation failures caused by process variations, aging and the like, and enhance the stability and reliability of the back-contact cell module 100 during the long-term use.

### Embodiment 9

Referring to Fig. 1 and Fig. 2, in some alternate embodiments, the thickness of the insulation structure 50 ranges from 25µm to 40µm.For example, the thickness of the insulation structure 50 can be 25µm, 26µm, 27µm, 28µm, 29µm, 30µm, 31µm, 32µm, 33µm, 34µm, 35µm, 36µm, 37µm, 38µm, 39µm or 40µm.

As such, the thickness of the insulation structure 50 is set within this range, such that the second grid line 122 can be physically insulated from the conductive connection structure 40, thereby ensuring the insulation of the second grid lines 122 from the conductive connection structure 40.

Exemplarily, the thickness of the insulation structure 50 can be set to be 30µm, which can ensure effective physical isolation, ensure good insulation of the second grid line 122 from the conductive connection structure 40, and improve the overall electrical performance and reliability of the back-contact cell module 100.

### Embodiment 10

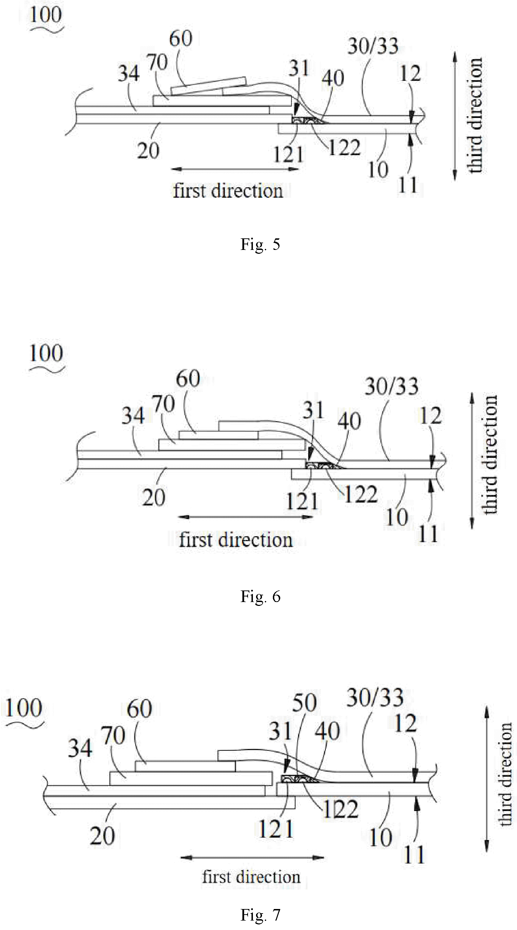

Referring to Fig. 5 and Fig. 6, in some alternate embodiments, when the back surface 12 of the first cell piece 10 and the front surface 11 of the second cell piece 20 are at least partially stacked together, the accommodation space 31 is formed at one side of the back surface 12 of the first cell piece 10 close to the second cell piece 20. The solder strip 30 further includes a second solder strip 33 and a third solder strip 34, wherein the second solder strip 33 is disposed on the back surface 12 of the first cell piece 10 and at least partially extends into the back surface 12 of the second cell piece 20, and the third solder strip 34 is positioned on the back surface 12 of the second cell piece 20.

As such, the back surface 12 of the first cell piece 10 and an edge portion of the front surface 11 of the second cell piece 20 are stacked together, which can effectively increase the light receiving area of the back-contact cell module 100.

### Embodiment 11

Referring to Fig. 1 and Fig. 3, in some alternate embodiments, an inclined surface 41 is formed on one side of the conductive connection structure 40 away from the first cell piece 10, and the inclined surface 41 is connected to the solder strip 30.

As such, the inclined surface 41 is consistent with an inclining direction of the solder strip 30, such that the conductive connection structure 40 can be better fit and connected to the solder strip 30, thereby ensuring the stability of connecting the conductive connection structure 40 and the solder strip 30.

### Embodiment 12

Referring to Fig. 5 and Fig. 6, in some alternate embodiments, the back-contact cell module 100 further includes a busbar 60 disposed on the back surface 12 of the second cell piece 20;
the busbar 60 is connected to the second solder strip 33 and positioned at one side of the second solder strip 33 facing away from the second cell piece 20; or
the busbar 60 is connected to the second solder strip 33 and positioned at one side of the second solder strip 33 close to the second cell piece 20.

Particularly, the busbar 60 is disposed at one side of the second solder strip 33 facing away from the second cell piece 20, which can avoid affecting the accommodation space 31 and components inside the accommodation space 31. The busbar 60 is disposed at one side of the second solder strip 33 close to the second cell piece 20, such that the volume of the accommodation space 31 can be increased, and further the size of the conductive connection structure 40 can be reasonably adjusted, thereby ensuring the connection stability.

### Embodiment 13

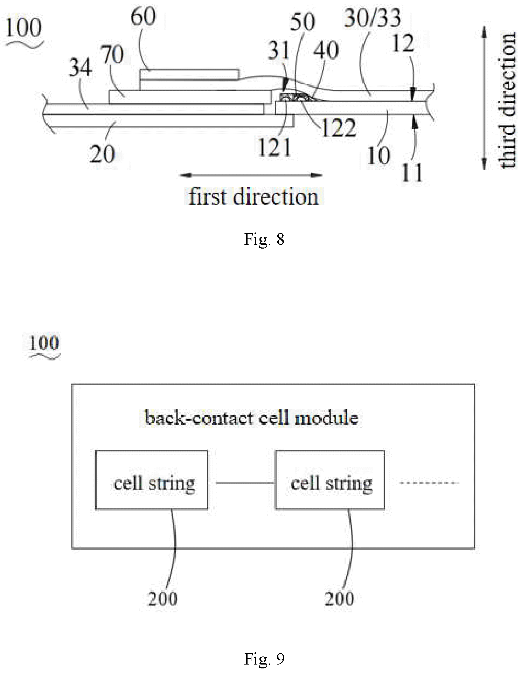

Referring to Fig. 7 and Fig. 8, in some alternate embodiments, when the front surface 11 of the first cell piece 10 and the back surface 12 of the second cell piece 20 are at least partially stacked together, the accommodation space 31 is formed at one side of the back surface 12 of the first cell piece 10 close to the second cell piece 20. The solder strip 30 further includes a second solder strip 33 and a third solder strip 34, wherein the second solder strip 33 is disposed on the back surface 12 of the first cell piece 10 and at least partially extends into the back surface 12 of the second cell piece 20, and the third solder strip 34 is positioned on the back surface 12 of the second cell piece 20.

Referring to Fig. 7 and Fig. 8, in some alternate embodiments, the back-contact cell module 100 further includes a busbar 60 disposed on the back surface 12 of the first cell piece 10;
the busbar 60 is connected to the second solder strip 33 and positioned at one side of the second solder strip 33 facing away from the second cell piece 20; or
the busbar 60 is connected to the second solder strip 33 and positioned at one side of the second solder strip 33 close to the second cell piece 20.

Particularly, the busbar 60 is disposed at one side of the second solder strip 33 close to the second cell piece 20, which can avoid affecting the accommodation space 31 and components inside the accommodation space 31. The busbar 60 is disposed at one side of the second solder strip 33 facing away from the second cell piece 20, such that the volume of the accommodation space 31 can be eliminated to a certain extent while the lifting radian of the second solder strip 33 can be reduced, thereby ensuring the connection stability.

It should be noted that when the busbar 60 is disposed between the cell piece and the second solder strip 33, it is necessary for insulating the busbar 60 and some grid lines so as to avoid the problem of short circuits occurring in the busbar 60.

In addition, in embodiments of the present disclosure, no restrictions are made to a specific position of the busbar so as to meet different requirements.

In some embodiments, referring to Fig. 5 to Fig. 8, the back-contact cell module further includes an insulation layer 70 disposed between the busbar 60 and the third solder strip 34. Fig. 5 to Fig. 8 further show the first grid line 121 and the second grid line 122, the description of which can refer to the above embodiments, and will be omitted here.

It should be noted that in such a way, components such as the busbar 60 and the insulation layer 70 can be disposed at one end of the second cell piece 20 away from the first cell piece 10, and the extension of the solder strip 30 from the first cell piece 10 into one side of the second cell piece 20 results in the increased accommodation space 31.

In some embodiments, the length L of the conductive connection structure 40 in the first direction meets the following relationship: 0 < L≤(D+d)/tanα, wherein α is an included angle between a direction in which the solder strip 30 is lifted and the first direction, D is a thickness of the second cell piece 20 in the third direction, d is a thickness of further components in the third direction, and the third direction is perpendicular to the second direction and the first direction. In this case, the length L of the conductive connection structure 40 in the first direction can be calculated from the thickness of the further components such as the second cell piece 20, the third solder strip 34, the busbar 60 and the insulation layer 70 in the third direction, and further the volume of the accommodation space 31 may be accurately calculated.

### Embodiment 14

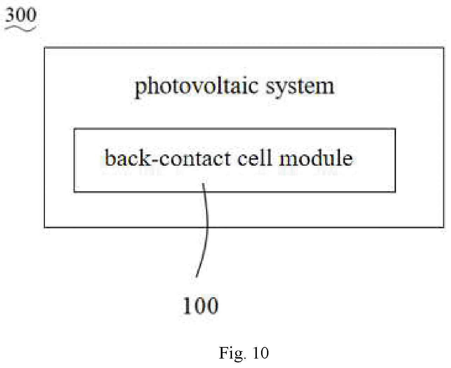

Referring to Fig. 9 and Fig. 10, the photovoltaic system provided in embodiments of the present disclosure includes the back-contact cell module 100 as described in any one of the above embodiments.

In the back-contact cell module 100 and the photovoltaic system 300 of embodiments of the present disclosure, the back-contact cell module 100 includes the cell string 200, the solder strip, the conductive connection structure and the insulation structure. The cell string 200 includes the first cell piece and the second cell piece adjacent to the first cell piece. The first cell piece and the second cell piece are arranged in the first direction. The first cell piece and the second cell piece are at least partially stacked together. The first grid line and the second grid line are formed on the back surfaces of the first cell piece and the second cell piece. The first grid line and the second grid line extend in the second direction and are alternately arranged in the first direction. The first grid line has the polarity opposite to that of the second grid line. The solder strip is disposed on the back surface of the first cell piece and extends in the first direction. The accommodation space is formed between one side of the first cell piece close to the second cell piece and the solder strip 30. The conductive connection structure is at least partially laid within the accommodation space and configured to connect the first grid line within the accommodation space and the solder strip. The insulation structure covers the second grid lines. The insulation structure is disposed within the accommodation space and positioned between the second grid line and the solder strip. As such, the solder strip can be connected to the first grid line within the accommodation space by means of the conductive connection structure, such that the electric currents within the accommodation space can be collected, and further the power generation efficiency of the back-contact cell module 100 is improved. Moreover, the insulation structure can be disposed between the second grid line and the conductive connection structure to avoid the problem of short circuits.

In such an embodiment, the photovoltaic system 300 can be applied in a photovoltaic power station, such as an above-ground power station, a rooftop power station, a floating power station, and the like, and can further be applied to equipment or a device utilizing solar energy to generate electricity, such as a solar power source of a user, a solar street lamp, a solar car and a solar building. Certainly, it should be understood that an application scenario of a photovoltaic system 300 is not limited to this, that is to say, the photovoltaic system 300 can be applied in all fields that require the use of the solar energy for power generation. Considering a photovoltaic power generation system network as an example, the photovoltaic system 300 can include a photovoltaic array, a combiner box and an inverter. The photovoltaic array can be an array combination of a plurality of back-contact cell modules 100. For example, the plurality of back-contact cell modules 100 can form a plurality of photovoltaic arrays. The photovoltaic arrays are connected to the combiner box. The combiner box can be configured to combine electric currents generated by the photovoltaic arrays. The combined electric current is converted into an alternating current required by a mains power grid via the inverter and then connected to the mains power grid to realize the solar power supply.

In the description of this specification, reference terms such as "one embodiment", "some embodiments", "examples", "specific examples", or "some examples" mean that particular features, structures, materials or features described in conjunction with embodiments or examples are included in at least one embodiment or example of the present disclosure. In this specification, schematic representations of the above terms do not necessarily refer to the same embodiments or example. Furthermore, the particular features, structures, materials, or features described may be combined in any one or more embodiments or examples in a proper manner.

In addition, the above embodiments are preferred embodiments of the present disclosure, and are not intended to limit the present disclosure. Any modifications, modifications, equivalent substitutions or improvements made within the spirit and principles of the present disclosure should be included within the scope of protection of the present disclosure.

## Claims

1. A back-contact cell module, comprising:
a cell string, comprising a first cell piece and a second cell piece adjacent to the first cell piece, wherein the first cell piece and the second cell piece are arranged in a first direction, the first cell piece and the second cell piece are at least partially stacked together, a first grid line and a second grid line are formed on back surfaces of the first cell piece and the second cell piece, the first grid line and the second grid line extend in a second direction and are arranged alternately in the first direction, and the first grid line has a polarity opposite to a polarity of the second grid line;
a solder strip, disposed on the back surface of the first cell piece and extending in the first direction, wherein an accommodation space is formed between one side of the first cell piece close to the second cell piece and the solder strip;
a conductive connection structure, at least partially laid within the accommodation space and configured to connect the first grid line within the accommodation space and the solder strip; and
an insulation structure, covering the second grid line, disposed within the accommodation space and positioned between the second grid line and the solder strip.

2. The back-contact cell module according to claim 1, wherein a length L of the conductive connection structure in the first direction meets the following relationship: 0 < L≤D/tanα; and
wherein α is an included angle between a direction in which the solder strip is lifted and the first direction, D is a thickness of the second cell piece in a third direction, and the third direction is perpendicular to the second direction and the first direction.

3. The back-contact cell module according to claim 1, wherein the solder strip comprises a first solder strip, wherein the first solder strip extends in the first direction and connects the back surface of the first cell piece and the back surface of the second cell piece, and an accommodation space is formed between one side of the first cell piece close to the second cell piece and the solder strip.

4. The back-contact cell module according to claim 1, wherein when the back surface of the first cell piece and a front surface of the second cell piece are at least partially stacked together, the accommodation space is formed at one side of the back surface of the first cell piece close to the second cell piece, the solder strip further comprises a second solder strip and a third solder strip, the second solder strip is disposed on the back surface of the first cell piece and at least partially extends into the back surface of the second cell piece, and the third solder strip is positioned on the back surface of the second cell piece.

5. The back-contact cell module according to claim 4, further comprising a busbar disposed on the back surface of the second cell piece;
the busbar is connected to the second solder strip and positioned at one side of the second solder strip facing away from the second cell piece; or
the busbar is connected to the second solder strip and positioned at one side of the second solder strip close to the second cell piece.

6. The back-contact cell module according to claim 1, wherein when a front surface of the first cell piece and the back surface of the second cell piece are at least partially stacked together, the accommodation space is formed at one side of the back surface of the second cell piece close to the first cell piece, the solder strip further comprises a second solder strip and a third solder strip, the second solder strip is disposed on the back surface of the first cell piece and at least partially extends into the back surface of the second cell piece, and the third solder strip is positioned on the back surface of the second cell piece.

7. The back-contact cell module according to claim 6, further comprising a busbar disposed on the back surface of the first cell piece;
the busbar is connected to the second solder strip and positioned at one side of the second solder strip facing away from the first cell piece; or
the busbar is connected to the second solder strip and positioned at one side of the second solder strip close to the first cell piece.

8. The back-contact cell module according to any one of claims 1 to 7, wherein the insulation structure is fabricated in a laying or coating manner.

9. The back-contact cell module according to any one of claims 1 to 7, wherein the conductive connection structure is a solder paste, a conductive adhesive or a further metal conductive material.

10. The back-contact cell module according to any one of claims 1 to 7, wherein a length L of the conductive connection structure in the first direction is greater than 6mm.

11. The back-contact cell module according to any one of claims 1 to 7, wherein a thickness of the conductive connection structure in the third direction ranges from 30µm to 300µm, wherein the third direction is perpendicular to the first direction and the second direction.

12. The back-contact cell module according to any one of claims 1 to 7, wherein in the second direction, a width of the solder strip is greater than a width of the conductive connection structure.

13. The back-contact cell module according to any one of claims 1 to 7, wherein in the second direction, a width of the insulation structure is greater than a width of the conductive connection structure.

14. The back-contact cell module according to any one of claims 1 to 7, wherein a thickness of the insulation structure ranges from 25µm to 40µm.

15. The back-contact cell module according to any one of claims 1 to 7, wherein an inclined surface is formed on one side of the conductive connection structure away from the first cell piece, and the inclined surface is connected to the solder strip.

16. The back-contact cell module according to claim 5 or 7, further comprising an insulation layer disposed between the busbar and the third solder strip.

17. The back-contact cell module according to claim 2, wherein an included angle α between a direction in which the solder strip is lifted and the first direction is adjusted according to a yield strength of the solder strip.

18. The back-contact cell module according to claim 17, wherein the yield strength of the solder strip is adjusted to be less than or equal to 75MPa.

19. The back-contact cell module according to claim 1, wherein a thickness D of the second cell piece in the third direction ranges from 90µm to 200µm.

20. A photovoltaic system, comprising the back-contact cell module according to any one of claims 1 to 19.
